Europäisches Patentamt

European Patent Office

Office européen des brevets

(11) Veröffentlichungsnummer: **0 299 199**
**A2**

## EUROPÄISCHE PATENTANMELDUNG

(21) Anmeldenummer: 88109142.5

(22) Anmeldetag: 08.06.88

(51) Int. Cl.⁴: **H05K 7/14 , H05K 7/18**

(30) Priorität: 15.07.87 DE 3723395

(43) Veröffentlichungstag der Anmeldung:
18.01.89 Patentblatt 89/03

(84) Benannte Vertragsstaaten:
AT BE CH DE FR GB IT LI NL SE

(71) Anmelder: **Siemens Aktiengesellschaft Berlin und München**
**Wittelsbacherplatz 2**
**D-8000 München 2(DE)**

(72) Erfinder: **Zell, Karl, Dipl.-Ing. FH**
**Moritz-von-Schwind-Weg 80**
**D-8134 Niederpöcking(DE)**
Erfinder: **Jäger, Egon, Dipl.-Ing. FH**
**Eduard-Thöny-Strasse 7**
**D-8000 München 71(DE)**
Erfinder: **Störk, Peter**
**Parkstrasse 36**
**D-8196 Eurasburg(DE)**
Erfinder: **Steiner, Günther, Dipl.-Ing. FH**
**Jaspersalle 9**
**D-8000 München 60(DE)**

(54) Baugruppenrahmen zur Aufnahme von einschiebbaren elektrischen Leiterplatten.

(57) Die Erfindung betrifft einen Baugruppenrahmen (1) zur Aufnahme von einschiebbaren, mit Bauelementen bestückten elektrischen Leiterplatten (5), die im eingeschobenen Zustand mittels Steckverbinder (6, 7) über eine Rückwandleiterplatte miteinander verbunden sind. Erfindungsgemäß sind im Baugruppenrahmen (1) in bestimmten Abständen eine vorgegebene Anzahl von Führungen (3) untereinander angeordnet, so daß Leiterplatten (5) mit einer geringeren Höhe als die Höhe des Baugruppenrahmens (1) in den Baugruppenrahmen (1) einschiebbar sind.

EP 0 299 199 A2

## Baugruppenrahmen zur Aufnahme von einschiebbaren elektrischen Leiterplatten

Die Erfindung betrifft einen Baugruppenrahmen zur Aufnahme von einschiebbaren, mit Bauelementen bestückten elektrischen Leiterplatten, die im eingeschobenen Zustand mittels Steckverbinder über eine Rückwandleiterplatte miteinander verbunden sind.

Derartige Baugruppenrahmen, in die elektrische Leiterplatten eingeschoben werden, sind allgemein bekannt. Bei diesen Baugruppenrahmen werden die einzelnen Leiterplatten in senkrechter Stellung eingeschoben. Dabei entsprechen die Abmessungen der Leiterplatten im wesentlichen der Höhe und der Tiefe des Baugruppenrahmens. Dieser Aufbau von Baugruppenrahmen mit einschiebbaren elektrischen Leiterplatten führt bei der Anwendung in variablen bzw. in Stufen erweiterbaren Gesamtsystemen zu erheblichen Nachteilen. Einer dieser Nachteile besteht darin, daß aufgrund der vorgegebenen Abmessungen der Leiterplatten keine optimale Anpassung an die jeweilige Größe des bestehenden Systems möglich ist. So führen die fest vorgegebenen Abmessungen der Leiterplatten entweder zu einer Über- oder zu einer Unterbestückung des Baugruppenrahmens.

Ein weiterer Nachteil ergibt sich daraus, daß es häufig erforderlich ist, größere Schaltungskomplexe in kleinere zusammensteckbare Einheiten aufzulösen. Dies geschieht in der Regel durch Aufteilung auf mehrere einschiebbare elektrische Leiterplatten, die über eine Rückwandleiterplatte miteinander verbunden sind. Müssen dabei aber sehr kleine Schaltungskomplexe austauschbar angeordnet werden, so sind diese als sogenannte Unterbaugruppen auf den Bestückungsseiten der Leiterplatten steckbar angeordnet. Da die Leiterplatten in der Regel innerhalb des Baugruppenrahmens in verhältnismäßig geringem Abstand senkrecht parallel nebeneinander angeordnet sind, tritt das Problem auf, daß für den Austausch eines Bauelementes bzw. einer Unterbaugruppe die gesamte Leiterplatte gezogen werden muß und damit außer Betrieb gesetzt wird.

Der vorliegenden Erfindung liegt die Aufgabe zugrunde, einen Baugruppenrahmen der eingangs genannten Art anzugeben, der eine optimale Anpassung der mit Bauelementen bestückbaren Flächen der elektrischen Leiterplatten an die jeweiligen Anforderungen ermöglicht.

Diese Aufgabe wird für einen Baugruppenrahmen der obengenannten Art erfindungsgemäß dadurch gelöst, daß innerhalb des Baugruppenrahmens in bestimmten Abständen parallel zu den Einschubebenen der Leiterplatten eine vorgegebene Anzahl von waagerecht verlaufenden Führungen untereinander angeordnet sind, und daß entsprechend der Anzahl der Führungen mit auf die Führungen passende Führungsrahmen versehene Leiterplatten mit einer dem Abstand der Führungen angepaßten Größe unabhängig voneinander mittels Steckverbinder mit der Rückwandleiterplatte verbindbar sind.

Durch die Einführung von Leiterplatten unterschiedlicher Größe, d. h. von Leiterplatten, deren Abmessungen nicht mehr nur im wesentlichen der Höhe und der Tiefe des Baugruppenrahmens entsprechen, ist mit dem erfindungsgemäßen Baugruppenrahmen innerhalb eines größeren Systems eine optimale Anpassung der mit Bauelementen bestückbaren Fläche, jeweils in Abhängigkeit von der Ausbaustufe des Systems möglich. Ein zusätzlicher Vorteil, der sich bei dem erfindungsgemäßen Baugruppenrahmen ergibt, besteht darin, daß sich bei einem Ausfall bestimmter elektrischer Bauelemente kleinere Ausfalleinheiten ergeben. Dies führt dazu, daß im Fehlerfall nicht unnötig viele Funktionseinheiten ausgetauscht werden müssen.

Eine vorteilhafte Weiterbildung des erfindungsgemäßen Baugruppenrahmens ist dadurch gekennzeichnet, daß die Höhe der einzelnen Baugruppen der ein- bzw. mehrfachen Länge eines bestimmten Modulschrittes der Steckverbindung beträgt.

Die heutigen Steckverbindungen sind modular aufgebaut, wobei der Modulschritt in der Länge eine SU (System Unitet) gleich 25 Millimeter beträgt. Dies entspricht dem Multimodul von 25 Millimeter nach DIN 43355. Mit Federleisten von 1,4 und 9 SU Länge ist eine Anpassung an unterschiedliche Leiterplattenhöhen möglich, so daß eine dem Anwendungsfall angepaßte Architektur einfach herzustellen ist.

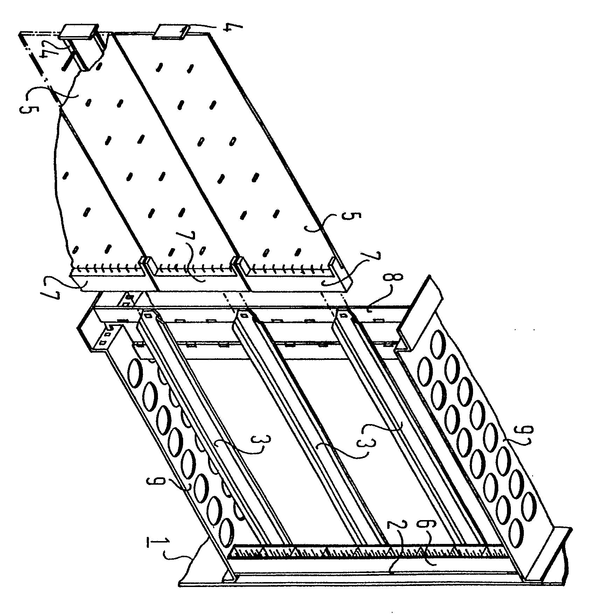

Im folgenden wird die Erfindung anhand eines in der Zeichnung dargestellten Ausführungsbeispieles näher erläutert.

Die dargestellte Figur zeigt in perspektivischer Ansicht einen Teil eines gemäß der Erfindung aufgebauten Baugruppenrahmens 1 sowie Teile von in diesen einschiebbare Leiterplatten 5. In der Darstellung des Ausführungsbeispieles sind lediglich die zum Verständnis der Erfindung notwendigen Teile des Baugruppenrahmens 1 bzw. der Leiterplatten 5 gezeigt.

Beim dargestellten Ausführungsbeispiel besteht der nur teilweise dargestellte Baugruppenrahmen 1 im wesentlichen aus zwei metallischen Lochplatten 9, die den Baugruppenrahmen 1 oben und unten begrenzen sowie aus der Rückwandleiterplatte 2, die den Baugruppenrahmen rückseitig begrenzt. Im dargestellten Beispiel sind drei untereinander angeordnete Führungen 3 vorgesehen, die z. B. aus profilierten Metallschienen bestehen. Entsprechend der Breite des Baugruppenrahmens können parallel zu den in der Figur gezeigten Führungen 3 weitere Führungen angeordnet sein. Dabei muß es sich nicht jeweils um drei untereinander angeordnete Führungen handeln, es können ebenso nur zwei Führungen oder aber auch mehr als drei Führungen untereinander vorgesehen werden.

Im dargestellten Ausführungsbeispiel werden die Führungen 3 an der Vorderseite des Baugruppenrahmens 1 an senkrecht verlaufenden Versteifungsschienen 8 befestigt, während die hinteren Enden der Führungen 3 in der Rückwandleiterplatte 2 gehalten sind.

Mit Hilfe der Führungen 3 sind entsprechend dimensionierte Leiterplatten 5 in den Baugruppenrahmen 1 einschiebbar. Die einzelnen Leiterplatten 5 besitzen entsprechende Führungsrahmen 4, die korrespondierend zu den Führungen 3 ausgebildet sind. An ihrem Ende besitzt jede Leiterplatte 5 einen der Höhe der Leiterplatte 5 angepaßtes Steckteil 7 eines Steckverbinders. Im dargestellten Ausführungsbeispiel handelt es sich dabei um ein Steckteil mit eingebauten Kontaktfedern. Als Gegenstück dient auf der Rückwandleiterplatte eine Zentrierleiste 6, die auf die Kontaktmesser der Rückwandleiterplatte 2 aufgeschoben ist und somit als Aufnahmeteil für die Kontaktfedern dient.

Üblicherweise sind derartige Zentrierleisten in eine Vielzahl gleich großer Abschnitte unterteilt. Es ist daher sinnvoll, bei der Bemessung der Leiterplatten 5 die Größe dieser Abschnitte der Zentrierleiste 6 zugrundezulegen.

In diesem Zusammenhang ist festzustellen, daß bei einer bestimmten Größe einer Leiterplatte aus Stabilitätsgründen für eine Leiterplatte auch zwei Führungen vorgesehen werden können.

## Ansprüche

1. Baugruppenrahmen zur Aufnahme von einschiebbaren, mit Bauelementen bestückten elektrischen Leiterplatten, die im eingeschobenen Zustand mittels Steckverbinder über eine Rückwandleiterplatte miteinander verbunden sind, **dadurch gekennzeichnet,** daß innerhalb des Baugruppenrahmens (1) in bestimmten Abständen parallel zu den Einschubebenen der Leiterplatten (5) eine beliebig vorgegebene Anzahl von waagerecht verlaufenden Führungen (3) untereinander angeordnet sind, und daß entsprechend der Anzahl der Führungen mit auf die Führungen (3) passende Führungsrahmen (4) versehene Leiterplatten (5) mit einer dem Abstand der Führungen (3) angepaßten Größe unabhängig voneinander mittels Steckverbinder (6, 7) mit der Rückwandleiterplatte (2) verbindbar sind.

2. Baugruppenrahmen nach Anspruch 1, **dadurch gekennzeichnet,** daß die Höhe der einzelnen Baugruppen (5) der ein- bzw. mehrfachen Länge eines bestimmten Modulschrittes der Steckverbindung (6, 7) beträgt.